# EUROPEAN PATENT SPECIFICATION

(11) **EP 1 740 032 B1**
(45) Date of publication and mention of the grant of the patent: **11.11.2009**
(21) Application number: 06252186.9
(22) Date of filing: 24.04.2006
(51) Int. Cl.: H05K 5/02, H01R 13/58

(54) **AC adapter**
Wechselstromadapter
Adaptateur pour courant alternatif

(30) Priority: 30.06.2005 JP 2005192404
(43) Date of publication of application: 03.01.2007
(73) Proprietor: Mitsumi Electric Co., Ltd., Tama-shi, Tokyo 206-8567 (JP)
(72) Inventor: Kajiwara, Terutomo c/o Kyushu Mitsumi Co., Ltd., Iizuka-Shi, Tokyo 820-5833 (JP); Wakafuji, Shuji c/o Kyushu Mitsumi Co., Ltd., Iizuka-Shi, Tokyo 820-5833 (JP); Katayama, Takayuki c/o Kyushu Mitsumi Co., Ltd., Iizuka-Shi, Tokyo 820-5833 (JP)
(74) Representative: Vinsome, Rex Martin

(56) References cited:
- JP-A- 2000 021 520
- JP-A- 2004 159 459
- US-A- 5 221 813
- US-A1- 2004 043 665

## Description

### BACKGROUND OF THE INVENTION

### 1. Field of the Invention

The present invention relates to an AC adapter for a portable device.

### 2. Description of the Related Art

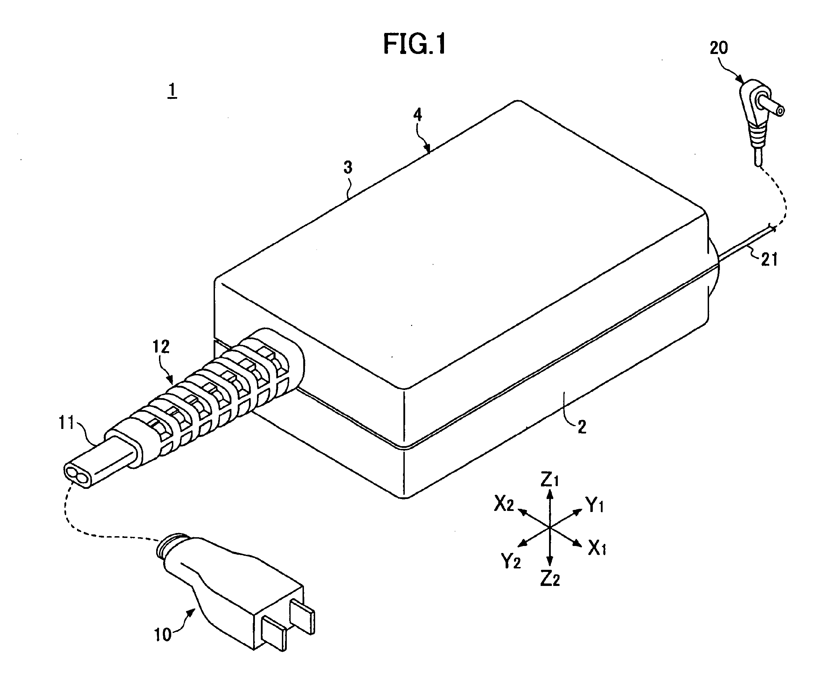

FIG. 1 is a diagram showing a configuration of an AC adapter with an AC cord as one example of an AC adapter for a portable device. The AC adapter 1 shown in FIG. 1 includes a switching regulator circuit that is accommodated within a case 4 realized by fitting together a lower half case 2 and an upper half case 3. The AC adapter 1 also includes an AC cord 11 having an AC plug 10 arranged at its extending end which AC cord 11 extends from one side of the case 4, and a DC cord 21 having a plug 20 arranged at its extending end which DC cord 21 extends from the other side of the case 4. The AC cord 11 includes a cord bushing 12 that is held between the lower half case 2 and the upper half case 3.

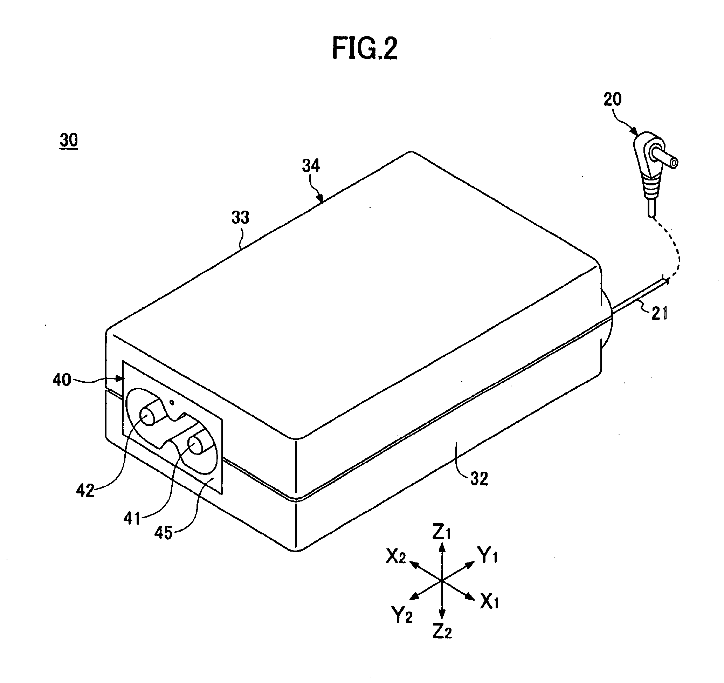

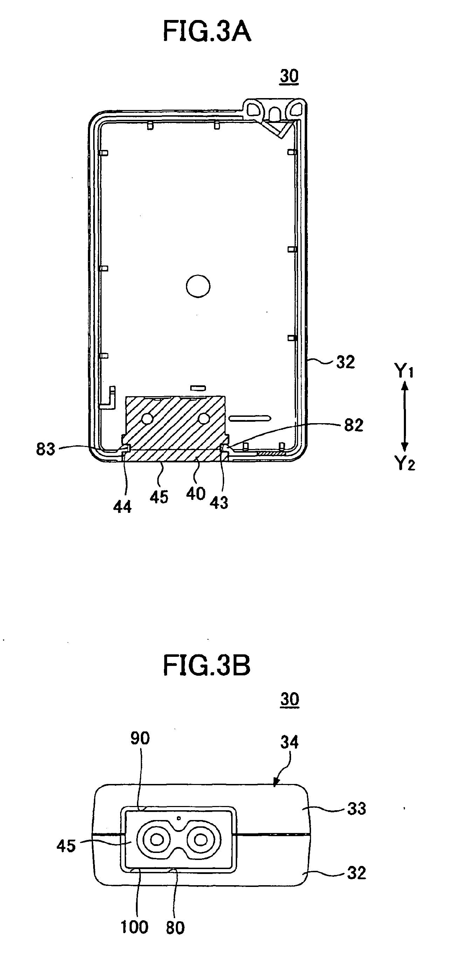

FIG. 2 and FIGS. 3A and 3B are diagrams showing a configuration of an AC adapter with an inlet plug as another example of an AC adapter for a portable device. The AC adapter 30 illustrated in these drawings includes a switching regulator and an inlet plug 40 that are accommodated within a case 34 realized by fitting together a lower half case 32 and an upper half case 33. The case 34 has an opening 100 that exposes an end face 45 at which terminals 41 and 42 of the inlet plug 40 are arranged. As is shown in FIG. 3A, the lower half case 32 includes rail portions 82 and 83 that engage with trenches 43 and 44 formed at the sides of the inlet plug 40, and in this way, the inlet plug 40 may be fixed in place with respect to the Y1-Y2 directions. It is noted that the external dimensions of the case 34 may be the same as the external dimensions of the case 4. Also, the depths of the lower half case 32 and the upper half case 33 may be arranged to be the same.

In this situation, although the lower half case 2 and the lower half case 32 may be similar in their structures, they differ in that the lower half case 2 includes a portion for holding the cord bushing 12 whereas the lower half case 32 includes a portion for holding the inlet plug 40. Also, although the upper half case 3 and the upper half case 33 may be similar in their structures, they differ in that the upper half case 3 includes a portion for holding the cord bushing 12 whereas the upper half case 33 includes a portion for holding the inlet plug 40.

Accordingly, a manufacturer that manufactures both the AC adapter 1 with an AC cord and the AC adapter 30 with an inlet plug has to prepare molds for the lower half case 2 and the upper half case 3 as well as molds for the lower half case 32 and the upper half case 33. Such a prerequisite may constitute an obstacle to the realization of speedy development and manufacture of an AC adapter for a new product.

Also, when using a different type of AC cord in the AC adapter 1, molds for a lower half case and an upper half case that are adapted for a different AC cord have to be prepared so that speedy response to a change in the type of AC cord used may not be easily realized.

US 2004/0043665 discloses a power adapter according to the preamble of claim 1.

A known cable bushing is disclosed in JP 2004 159459.

### SUMMARY OF THE INVENTION

According to an embodiment of the present invention, a technique is provided for realizing an AC adapter with an AC cord using lower and upper half cases of an AC adapter with an inlet plug.

According to the present invention, there is provided an AC adapter including a case made up of a lower half case and an upper half case that are fit together, and an AC cord including a cord bushing, wherein the lower half case includes a first side plate at which a first concave portion is arranged;
characterized by an AC cord holding spacer configured to hold the AC cord;
wherein the upper half case includes a second side plate at which a second concave portion is arranged;
the first concave portion and the second portion are arranged to oppose each other to form an opening when the lower half case and the upper half case are fit together;
the AC cord holding spacer has external dimensions corresponding to dimensions of the opening and includes an AC cord concave portion that engages the cord bushing of the AC cord; and
the AC cord holding spacer is configured to engage the opening when the AC cord concave portion engages the cord bushing of the AC cord.

According to an aspect of the present invention, design changes may be made on the AC cord holding spacer that is relatively small in size while leaving the lower half case and the upper half case unchanged in response to a change in the type of AC cord used, for example, so that speedy response may be realized with respect to such a change. According to another aspect of the present invention, the dimensions of the opening may be arranged to correspond to the dimensions of an inlet plug so that the lower half case and the upper half case may be commonly used for realizing an AC adapter with an AC cord as well as an AC adapter with an inlet plug.

### BRIEF DESCRIPTION OF THE DRAWINGS

FIG. 1 is a perspective view of an AC adapter with an AC cord as an example of an AC adapter for a portable device;
FIG. 2 is a perspective view of an AC adapter with an inlet plug as another example of an AC adapter for a portable device;
FIGS. 3A and 3B are cross-sectional and end views, respectively, of the AC adapter with the inlet plug shown in FIG. 2;
FIG. 4 is a perspective view of an AC adapter with an AC cord according to an embodiment of the present invention;
FIG. 5 is an exploded perspective view of an AC cord holding portion of the AC adapter shown in FIG. 4;
FIGS. 6A-6C are partial cross-sectional views of the AC adapter shown in FIG. 4;
FIGS. 7A-7F are diagrams showing an AC cord holding spacer of the AC adapter shown in FIG. 4; and
FIGS. 8A and 8B are diagrams illustrating a case in which the AC cord holding spacer is disposed upside down upon assembling the AC adapter shown in FIG. 4.

### DETAILED DESCRIPTION OF THE PREFERRED EMBODIMENTS

In the following, preferred embodiments of the present invention are described with reference to the accompanying drawings.

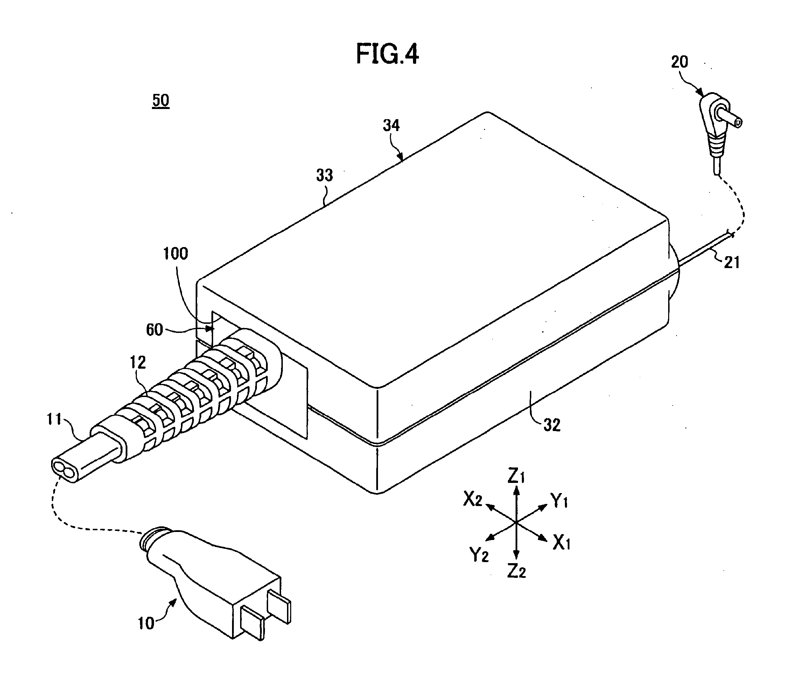

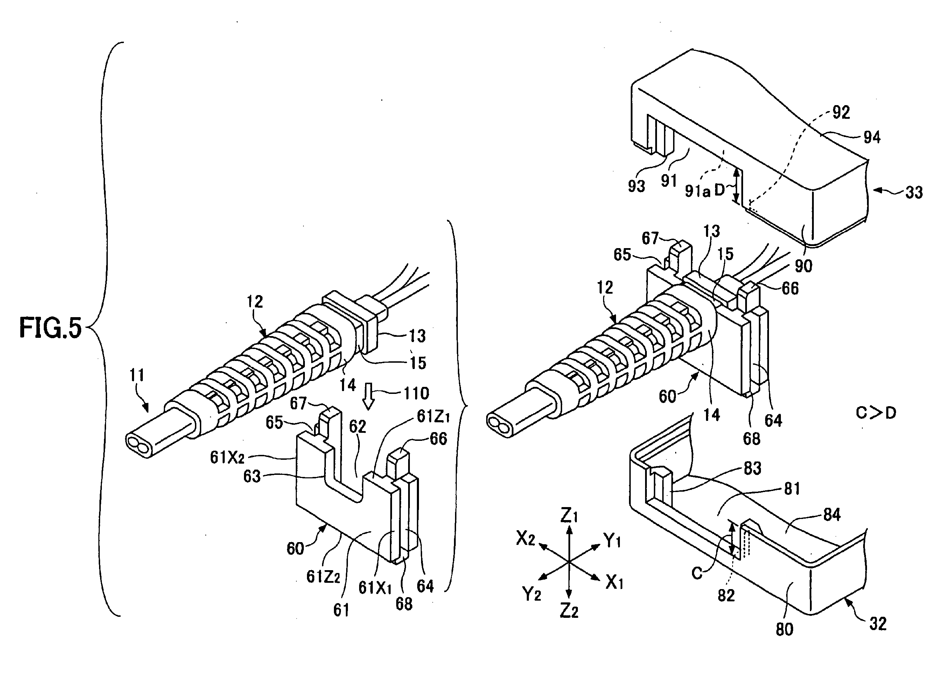

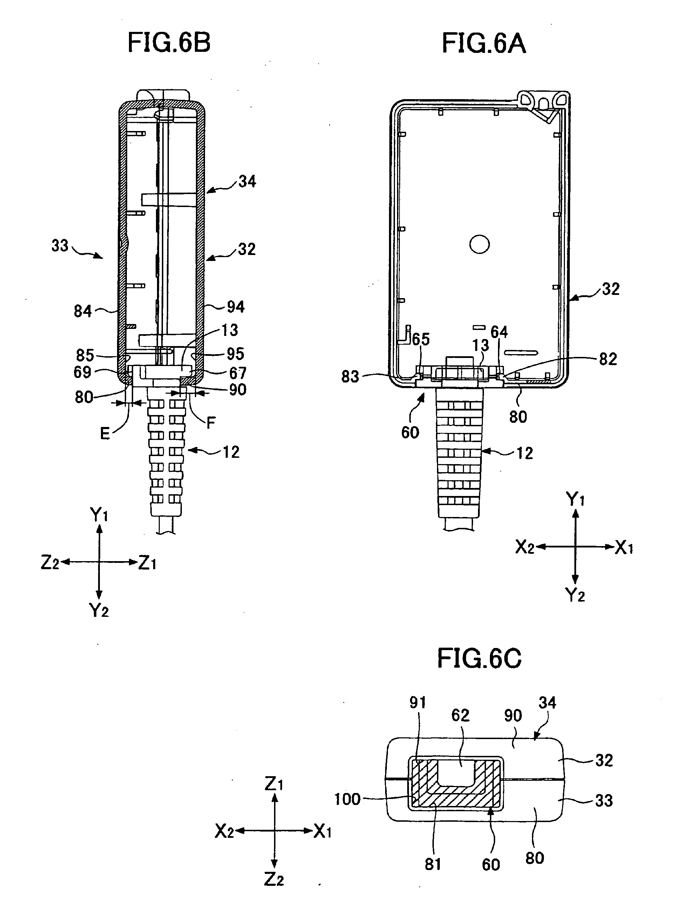

FIG. 4 is a diagram showing a configuration of an AC adapter with an AC cord for a portable device according to an embodiment of the present invention. FIG. 5 is an exploded view of an AC cord holding portion of the AC adapter shown in FIG. 4. FIGS. 6A-6C are partial cross-sectional views of the AC adapter shown in FIG. 4. It is noted that in these drawings, components that are identical to those described in relation to FIGS. 1, 2, 3A, and 3B are given the same numerical references. Also, it is noted that in these drawings, directions X1-X2 represent width directions, directions Y1-Y2 represent length directions, and directions Z1-Z2 represent height directions.

The AC adapter 50 illustrated in FIG. 4 includes an AC cord holding spacer 60 and the case 34 used in the AC adapter 30 with an inlet plug that is realized by fitting together the lower half case 32 and the upper half case 33. Also the AC adapter 50 includes an AC cord 11 having an AC plug 10 arranged at its extending end which AC cord 11 extends from one side of the case 34, and a DC cord 21 having a plug 20 arranged at its extending end which DC cord 21 extends from the opposite side of the case 34.

### [Configuration of AC Cord 11]

As is shown in FIG. 5, a cord bushing 12 of the AC cord 11 includes two opposing flange portions 13 and 14 and a trench portion 15 arranged between the flange portions 13 and 14.

### [Configuration of AC Cord Holding Spacer 60]

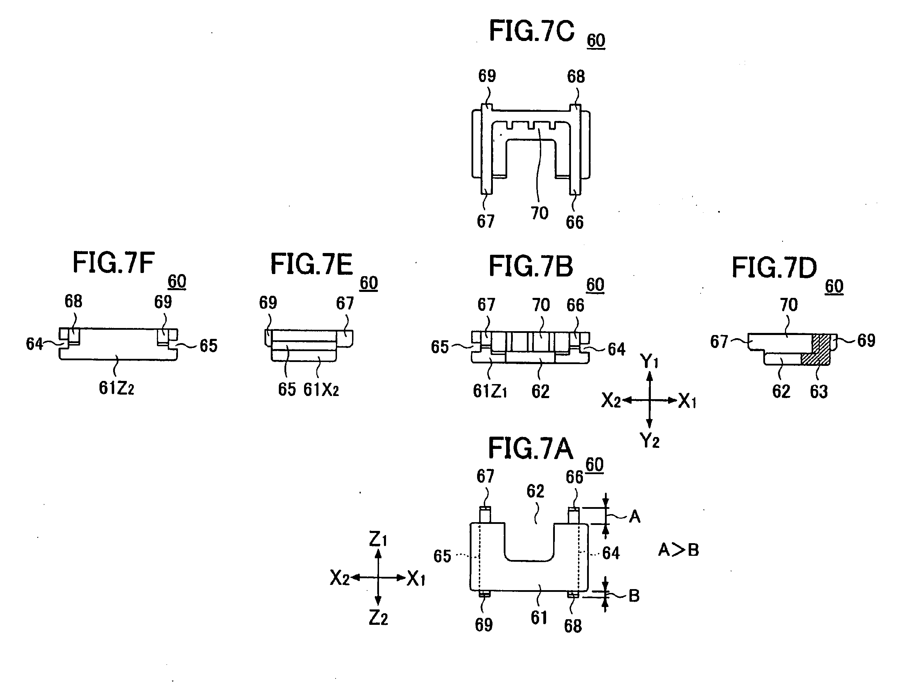

As is shown in FIG. 5 and FIGS. 7A-7F, the AC cord holding spacer 60 is a molded object made of synthetic resin that includes a main body 61 of which the external shape is arranged to be the same rectangular shape as that of the end face 45 of the inlet plug 40 shown in FIG. 2. The AC cord holding spacer 60 also includes an AC cord concave portion 62, trenches 64 and 65, upper protruding portions 66 and 67, and lower protruding portions 68 and 69 that are arranged at the main body 61. The main body 61 includes an end face 61Z1 at the Z1 side, an end face 61Z2 at the Z2 side, an end face 61X1 at the X1 side, and an end face 61X2 at the X2 side.

The AC cord concave portion 62 is created by cutting the end face 61Z1 of the main body 61a in the Z2 direction to form a concave shape portion. The shape and dimensions of the AC cord concave portion 62 are arranged to correspond to the shapes and dimensions of the flange portions 13 and 14 and the trench portion 15 of the cord bushing 12 of the AC cord 11. The AC cord concave portion 62 is defined by a rim portion 63 that is arranged into a U shape with its dimension in the X directions being longer than its dimension in the Z directions.

The trench 64 is arranged at the end face 61X1 of the main body 61 and extends in the Z1-Z2 directions. The trench 65 is arranged at the end face 61X2 of the main body 61 and extends in the Z1-Z2 directions.

The upper protruding portions 66 and 67 are arranged to protrude in the Z1 direction from the end face 61Z1 close to where the trenches 64 and 65 are formed. The lower protruding portions 68 and 69 are arranged to protrude in the Z2 direction from the end face 61Z2 close to where the trenches 64 and 65 are formed. It is noted that the protruding dimension A of the upper protruding portions 66 and 67 is arranged to be greater than the protruding dimension B of the lower protruding portions 68 and 69 (i.e., A > B).

Also, it is noted that a flange accommodating portion 70 is formed at the Z2 side of the Y1 side surface of the main body 61.

### [Configurations of Lower Half Case 32 and Upper Half Case 33]

As is shown in FIG. 5, the lower half case 32 has a Y2 side plate 80 at which a first concave portion 81 is formed into a U shape. Also, the lower half case 32 has rail portions 82 and 83 arranged at the X1 side and X2 side of the first concave portion 81, respectively, the rail portions 82 and 83 each extending in the Z1-Z2 directions. The upper half case 33 has a Y2 side plate 90 at which a second concave portion 91 is formed into a reversed U shape. Also, the upper half case 33 has rail portions 92 and 93 arranged at the X1 side and X2 side of the second concave portion 91, respectively, the rail portions 92 and 93 each extending in the Z1-Z2 directions. It is noted that the depth C of the first concave portion 81 is arranged to be greater than the depth D of the second concave portion 91 (i.e., C > D). When the lower half case 32 and the upper half case 33 are fit together, the first concave portion 81 and the second concave portion 91 oppose each other to form a rectangular opening 100 as is shown in FIG. 6C.

Referring to FIG. 6B, dimension E represents the distance in the Z directions between the edge of the first concave portion 81 and an inner face 85 of a bottom plate 84 of the lower half case 32, and dimension F represents the distance in the Z directions between the edge of the second concave portion 91 and an inner face 95 of an upper plate 94 of the upper half case 32. In this situation, since the lower half case 32 and the upper half case 33 have the same depth and C > D, dimension F is greater than dimension E (i.e., E < F). It is noted that the protruding dimension A of the upper protruding portions 66 and 67 corresponds to the dimension F, and the protruding dimension B of the lower protruding portions 68 and 69 correspond to the dimension E.

### [Bound State of AC Cord 11]

In the following, the bound state of the AC cord 11 of the AC adapter 50 of the present embodiment is described.

### [AC Cord 11 and AC Cord Holding Spacer 60]

The trench portion 15 of the cord bushing 12 of the AC cord 11 engages the AC cord concave portion 62 of the AC cord holding spacer 60 as is illustrated by the arrow 110 shown in FIG. 5. Also, the respective edges of the flange portions 13 and 14 engage the rim portion 63 at three sides as is shown in FIGS. 5 and 6A. It is noted that the tip side of the flange portion 13 is accommodated within the flange accommodating portion 70.

In this way, the AC cord 11 is bound to be prevented from moving in the Y1-Y2 directions by the AC cord holding spacer 60.

### [AC Cord Holding Spacer 60 and Case 34]

As is shown in FIG. 5, the AC cord holding spacer 60 holding the cord bushing 12 of the AC cord 11 may be arranged to engage the first concave portion 81 of the lower half case 32 so that the Z2 side half of the AC cord holding spacer 60 engages the first concave portion 81. Then, the upper half case 33 may be arranged to engage the lower half case from the Z1 side so that the Z1 side half of the AC cord holding spacer 60 engages the second concave portion 91.

In this way, the main body 61 may be accommodated within the opening 100 to thereby seal the opening 100 as is shown in FIG. 6C. Also, the rail portion 82 engages the Z2 side half of the trench 64, the rail portion 83 engages the Z2 side half of the trench 65, the rail portion 92 engages the Z1 side half of the trench 64, and the rail portion 93 engages the Z1 side half of the trench 65 as is shown in FIGS. 6A and 6C. Also, the lower protruding portions 68 and 69 engage an inner face portion located between the first concave portion 81 of the side plate 80 and the bottom plate 84 as is shown in FIG. 6B. Similarly, the upper protruding portions 66 and 67 engage an inner face portion located between the second concave portion 91 of the side plate 90 and the upper plate 94.

In this way, the AC cord holding spacer 60 is bound to be prevented from moving in the Y1-Y2 directions by the case 34. It is particularly noted that the AC cord holding spacer 60 is prevented from moving in the Y2 direction, namely the direction in which the AC cord 11 is pulled with respect to the case 34, by the upper protruding portions 66 and 67 and the lower protruding portions 68 and 69.

In turn, the AC cord 11 is prevented from moving in the Y1-Y2 directions with respect to the case 34. It is particularly noted that the AC cord 11 is bound at all four sides (i.e., upper, lower, left, and right sides) to be prevented from moving in the Y2 direction; namely, the direction in which the AC cord 11 is pulled with respect to the case 34. In other words, the AC cord 11 is bound more tightly against movement in the pulling direction compared to the direction in which the AC cord 11 is pushed with respect to the case 34.

Also, the inner side rim portion 91a of the second concave portion 91 of the side plate 90 is arranged between the Z1 side portion of the flange 13 and the Z1 side portion of the flange 14, so that a portion of the case 34 engages a portion of the cord bushing 12 as is shown in FIG. 5.

As can be appreciated from the above descriptions, according to an embodiment of the present invention, the AC cord holding spacer 60 may be used to fix the AC cord 11 to the case 34 made up of the lower half case 32 and the upper half case 33 used for realizing the AC adapter 30 with an inlet plug. According to an aspect of the present embodiment, design changes that require time and cost do not have to be made with respect to the lower half case 32 and the upper half case 33, and instead, design changes may be made on the AC cord holding spacer 60 that is small in size and can be easily redesigned. In this way, speedy response to a change in the type of AC cord may be realized, for example.

### [Preventive Measures against Misplacement of AC Cord Holding Spacer 60]

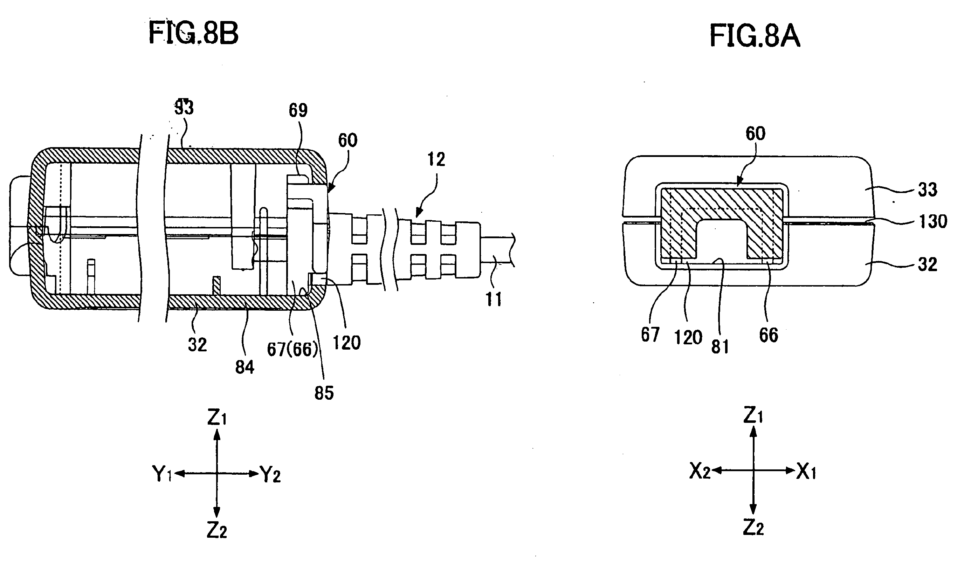

In the following, referring to FIGS. 8A and 8B, a case is described in which the AC cord holding spacer 60 is inverted with respect to the Z1-Z2 directions upon assembling the AC adapter 50.

When the AC cord holding spacer 60 is inverted with respect to the Z1-Z2 directions upon assembling the AC adapter 50, the protruding portions 66 and 67 hit against the inner face 85 of the bottom plate 85 so that the main body 61 may not properly engage with the first concave portion 81 as is shown in FIGS. 8A and 8B. That is, the main body 61 is disposed slightly apart from the Z2 side edge of the first concave portion 81 so that a gap is created between the main body 61 and the first concave portion 81. In turn, upon engaging the upper half case 33 with the lower half case 32, the edge of upper half case 33 does not come into contact with the edge of the lower half case 32 and a gap 130 is created between the lower half case 32 and the upper half case 33. Accordingly, the upper half case 33 may not be fixed to the lower half case 32, and at this point, it may be determined that the AC cord holding spacer 60 is misplaced so that the AC adapter 50 may be prevented from being completely assembled with the AC cord holding spacer 60 disposed in such a state.

Further, it is noted that the present invention is not limited to the specific embodiments described above, and variations and modifications may be made without departing from the scope of the present invention.

## Claims

1. An AC adapter (50) including a case (34) made up of a lower half case (32) and an upper half case (33) that are fit together, and an AC cord (11) including a cord bushing (12) with a trenchportion (15), wherein the lower half case includes a first side plate (80) at which a first concave portion (81) is arranged;
**characterized by**:
an AC cord holding spacer (60) configured to hold the AC cord;
wherein the upper half case (33) includes a second side plate (90) at which a second concave portion (91) is arranged;
the first concave portion (81) and the second portion (91) are arranged to oppose each other to form an opening when the lower half case and the upper half case are fit together;
the AC cord holding spacer (60) has external dimensions corresponding to dimensions of the opening and includes an AC cord concave portion (62) that engages the cord bushing trench portion (15); and
the AC cord holding spacer is configured to engage the opening when the AC cord concave portion engages the cord bushing trench portion (15).

2. The AC adapter as claimed in claim 1, wherein
the dimensions of the opening correspond to dimensions of an inlet plug.

3. The AC adapter as claimed in claim 1, wherein
the AC cord holding spacer includes a first trench (64) and a second trench (65) formed at a first side and a second side of the AC cord holding spacer, respectively;
the first concave portion of the lower half case includes a first rail portion (82) and a second rail portion (83) that are configured to engage the first trench and the second trench, respectively; and
the second concave portion includes a third rail portion (92) and a fourth rail portion (93) that are configured to engage the first trench and the second trench, respectively.

4. The AC adapter as claimed in claim 3, wherein
the AC cord holding spacer includes a lower protruding portion (68, 69) that protrudes downward and an upper protruding portion (66, 67) that protrudes upward;
the lower protruding portion engages an inner side of the first side plate of the lower half case; and
the upper protruding portion engages an inner side of the second side plate of the upper half case.

5. The AC adapter as claimed in claim 4, wherein
the first concave portion and the second concave portion have differing depths;
the lower protruding portion and the upper protruding portion have differing lengths; and
a longer one of the lower protruding portion and the upper protruding portion is configured to prevent the lower half case and the upper half case from properly fitting together when the AC cord holding spacer is disposed upside down upon engaging the opening.

## Patentansprüche

1. AC-Adapter (50), welcher ein Gehäuse (34), welches aus einer unteren Gehäusehälfte (32) und einer oberen Gehäusehälfte (33) aufgebaut ist, welche aneinander befestigt sind, und ein AC-Kabel (11) enthält, welches eine Kabelbuchse (12) mit einem vertieften Abschnitt (15) enthält, wobei die untere Gehäusehälfte eine erste Seitenplatte (80) enthält, an welcher ein erster konkaver Abschnitt (81) angeordnet ist;
**gekennzeichnet durch**:
einen AC-Kabelhalter-Abstandshalter (60), welcher konfiguriert ist, um das AC-Kabel zu halten;
wobei die obere Gehäusehälfte (33) eine zweite Seitenplatte (90) enthält, an welcher ein zweiter konkaver Abschnitt (91) angeordnet ist;
wobei der erste konkave Abschnitt (81) und der zweite Abschnitt (91) angeordnet sind, um sich einander gegenüber zu liegen, um eine Öffnung zu bilden, wenn die untere Gehäusehälfte und die obere Gehäusehälfte miteinander befestigt sind;
wobei der AC-Kabelhalter-Abstandshalter (60) äußere Dimensionen aufweist, welche den Dimensionen der Öffnung entsprechen und einen AC-Kabel-Konkavabschnitt (62) enthält, der den vertieften Abschnitt (15) der Kabelbuchse in Eingriff nimmt; und
wobei der AC-Kabelhalter-Abstandshalter (60) konfiguriert ist, um die Öffnung in Eingriff zu nehmen, wenn der AC-Kabels-Konkavabschnitt den vertieften Abschnitt (15) der Kabelbuchse in Eingriff nimmt.

2. AC-Adapter gemäß Anspruch 1, wobei die Dimensionen der Öffnung den Dimensionen eines Eingangssteckers entsprechen.

3. AC-Adapter gemäß Anspruch 1, wobei der AC-Kabelhalter-Abstandshalter einen ersten Einschnitt (64) und einen zweiten Einschnitt (65) aufweist, welche an einer ersten Seite bzw. einer zweiten Seite des AC-Kabelhalter-Abstandshalters gebildet sind;
wobei der erste konkave Abschnitt der unteren Gehäusehälfte einen ersten Schienenabschnitt (82) und einen zweiten Schienenabschnitt (83) enthält, welche konfiguriert sind, um den ersten Einschnitt bzw. den zweiten Einschnitt in Eingriff zu nehmen; und
wobei der zweite konkave Abschnitt einen dritten Schienenabschnitt (92) und einen vierten Schienenabschnitt (93) enthält, welche konfiguriert sind, um den ersten Einschnitt bzw. den zweiten Einschnitt in Eingriff zu nehmen.

4. AC-Adapter gemäß Anspruch 3, wobei der AC-Kabelhalter-Abstandshalter einen unteren liervorstehenden Abschnitt (68, 69) enthält, welcher nach unten hervorsteht und einen oberen hervorstehenden Abschnitt (66, 67), welcher nach oben hervorsteht;
wobei der untere hervorstehende Abschnitt eine innere Seite der ersten Seitenplatte der unteren Gehäusehälfte in Eingriff nimmt; und
wobei der obere hervorstehende Abschnitt eine innere Seite der zweiten Seitenplatte der oberen Gehäusehälfte in Eingriff nimmt.

5. AC-Adapter gemäß Anspruch 4, wobei
der erste konkave Abschnitt und der zweite konkave Abschnitt unterschiedliche Tiefen aufweisen;
der untere hervorstehende Abschnitt und der obere hervorstehende Abschnitt unterschiedliche Längen aufweisen; und
ein längerer von dem unteren hervorstehenden Abschnitt und dem oberen hervorstehenden Abschnitt konfiguriert ist, um zu verhindern, dass die untere Gehäusehälfte und die obere Gehäusehälfte richtig zusammenpassen, wenn der AC-Kabelhalter-Abstandshalter bei dem in Eingriff nehmen der Öffnung umgedreht angeordnet ist.

## Revendications

1. Adaptateur pour courant alternatif (50) comprenant un boîtier (34) composé d'une moitié de boîtier inférieure (32) et d'une moitié de boîtier supérieure (33) qui sont fixées ensemble, et d'un câble CA (11) comprenant un serre-câble (12) avec une partie rainurée (15), dans lequel la moitié de boîtier inférieure comprend une première plaque latérale (80) sur laquelle est agencée la première partie concave (81) ;
**caractérisé par** :
un dispositif d'espacement supportant le câble CA (60) configuré pour supporter le câble CA ;
dans lequel la moitié de boîtier supérieure (33) comprend une seconde plaque latérale (90) sur laquelle est agencée une seconde partie concave (91) ;
la première partie concave (81) et la seconde partie (91) sont disposées en vis-à-vis pour former une ouverture lorsque la moitié du boîtier inférieure et la moitié de boîtier supérieure sont fixées ensemble ;
le dispositif d'espacement (60) supportant le câble CA possède des dimensions externes correspondant aux dimensions de l'ouverture et comprend une partie concave de câble CA (62) dans laquelle s'engage la partie rainurée (15) du serre-câble ; et
le dispositif d'espacement (60) supportant le câble CA est configuré pour venir en contact de l'ouverture lorsque la partie concave de câble CA vient en contact de la partie rainurée (15) du serre-câble.

2. Adaptateur pour courant alternatif selon la revendication 1, dans lequel les dimensions de l'ouverture correspondent aux dimensions d'un connecteur d'entrée.

3. Adaptateur pour courant alternatif selon la revendication 1, dans lequel le dispositif d'espacement supportant le câble CA comprend une première tranchée (64) et une seconde tranchée (65) formées sur un premier côté et un second côté du dispositif d'espacement supportant le câble CA, respectivement ;
la première partie concave de la moitié de boîtier inférieure comprend une première partie de rail (82) et une seconde partie de rail (83) qui sont configurées pour venir en contact de la première tranchée et la seconde tranchée, respectivement ; et
la seconde partie concave comprend une troisième partie de rail (92) et une quatrième partie de rail (93) qui sont configurées pour venir en contact de la première tranchée et la seconde tranchée, respectivement.

4. Adaptateur pour courant alternatif selon la revendication 3, dans lequel le dispositif d'espacement supportant le câble CA comprend une partie inférieure saillante (68, 69) qui fait saillie vers le bas et une partie supérieure saillante (66, 67) qui fait saillie vers le haut ;
la partie saillante inférieure vient en contact d'un côté interne de la première plaque latérale de la moitié de boîtier inférieure ; et
la partie saillante supérieure vient en contact d'un côté interne de la seconde plaque latérale de la moitié de boîtier supérieure.

5. Adaptateur pour courant alternatif selon la revendication 4, dans lequel
la première partie concave et la seconde partie concave présentent des profondeurs différentes ;
la partie saillante inférieure et la partie saillante supérieure présentent des longueurs différentes ; et
une partie plus longue de la partie saillante inférieure et de la partie saillante supérieure est configurée pour empêcher la moitié de boîtier inférieure et la moitié de boîtier supérieure d'être fixées correctement lorsque le dispositif supportant le câble CA est disposé de façon inverse lors de l'engagement dans l'ouverture.
